# EUROPEAN PATENT APPLICATION

(11) **EP 2 508 905 A2**
(43) Date of publication of application: **10.10.2012**
(21) Application number: 12161352.5
(22) Date of filing: 26.03.2012
(51) Int. Cl.: G01R 31/36

(54) **Battery voltage detector**

(30) Priority: 30.03.2011 JP 2011075302
(71) Applicant: Keihin Corporation, Tokyo (JP)
(72) Inventor: Tsuchiya, Shingo, Tochigi-ken (JP); Kamata, Seiji, Tochigi-ken (JP)
(74) Representative: Ilgart, Jean-Christophe

(57) **Abstract**

A battery voltage detector includes a voltage detection circuit (D1) and a voltage processor (M). The voltage detection circuit (D1) detects a cell voltage of a first battery cell (C1). The voltage detection circuit (D1) includes a plurality of capacitors which are simultaneously charged by the first battery cell (C1). The voltage processor (M) processes the detection result of the first cell voltage. The voltage detection circuit (D1) outputs the voltages between both terminals of the plurality of capacitors as the cell voltages to the voltage processor (M) at different timing. The voltage processor (M) judges whether or not a false detection of the cell voltage occurs based on the cell voltages obtained from the voltage detection circuit (D1) at different timing.

## Description

### BACKGROUND OF THE INVENTION

### Field of the Invention

The present invention generally relates to a battery voltage detector.

### Description of Related Art

As is generally known, vehicles such as electric vehicles and hybrid vehicles are equipped with a motor which is a power source and a battery of high voltage and large capacitance, which supplies electric power to the motor. The battery is configured by serially connecting a plurality of battery cells such as lithium-ion batteries or nickel-hydrogen batteries. Cell balance control in which cell voltages of each battery cell are monitored and the cell voltages are homogenized has been performed in order to maintain the performance of the battery.

In detection of the cell voltage, a flying capacitor-type voltage detection circuit, which does not require a dedicated insulating power source and an insulator, is mainly used. In the flying capacitor-type voltage detection circuit, the cell voltage of the measuring object is detected lower than an actual value when leakage current of a flying capacitor and a sampling switch is increased because of aging thereof. As a result, accuracy of the cell balance control may be lowered because the correct cell voltage cannot be obtained.

Japanese Unexamined Patent Application, First Publication, No. 2002-291167 discloses the following method that overcomes the above-described defect of the flying capacitor-type voltage detection circuit. The cell voltage of the battery cell, which is the measuring subject, is detected by the flying capacitor-type voltage detection circuit at a different timing in chronological order. A voltage just after starting a charge of the flying capacitor, which can be regarded as the actual value of the cell voltage, is estimated based on the voltage attenuation property of the cell voltage, which is obtained from the detected result.

### SUMMARY OF THE INVENTION

Japanese Unexamined Patent Application, First Publication, No. 2002-291167 discloses a technology in which an accurate cell voltage is detected by the flying capacitor-type voltage detection circuit. More specifically, the cell voltage, which can be regarded as the actual value, is estimated by arithmetic processing. However, the technology disclosed by Japanese Unexamined Patent Application, First Publication, No. 2002-291167 is not directed to detect an occurrence of a false detection of the cell voltage caused by aging. It is important for properly controlling the battery to detect the cell voltage correctly. However, it is also important to detect the occurrence of a false detection of the cell voltage, that is, the generation of a defect of the circuit.

One embodiment of the present invention has been made in view of the circumstances described above, and has an object to provide a battery voltage detector that can detect the occurrence of a false detection of a cell voltage due to aging of a voltage detection circuit.

In order to accomplish the above object, according to one embodiment of the present invention, a battery voltage detector may include, but is not limited to, a voltage detection circuit and a voltage processor. The voltage detection circuit detects a first cell voltage of a first battery cell. The voltage processor processes the detection result of the first cell voltage. The voltage detection circuit includes a plurality of capacitors which are simultaneously charged by the first battery cell. The voltage detection circuit outputs the voltages between both terminals of the plurality of capacitors as the cell voltages to the voltage processor at different timing. The voltage processor judges whether or not a false detection of the cell voltage occurs based on the cell voltages obtained from the voltage detection circuit at different timing.

In some cases, the battery voltage detector may include, but is not limited to, the voltage processor judging that the false detection of the first cell voltage occurred when a difference of the plurality of second cell voltages exceeds a predetermined threshold value.

In some cases, the battery voltage detector may include, but is not limited to, the voltage detection circuit being provided with each of a plurality of second battery cells including the first battery cell. Each of the voltage detection circuits includes a first input terminal, a second input terminal, a first output terminal, a second output terminal, a first capacitor, a second capacitor, a first switch group, a fourth switch, a fifth switch, and a sixth switch. The first input terminal is coupled to a positive terminal of the battery cell. The second input terminal is coupled to a negative terminal of the battery cell. The first output terminal is coupled to the voltage processor. The second output terminal is coupled to a common line. The first capacitor is coupled between a first high voltage line and a low voltage line. The first high voltage line couples the first input terminal and the first output terminal. The low voltage line couples the second input terminal and the second output terminal. The second capacitor is coupled between a second high voltage line and the low voltage line. The second high voltage line is coupled to the first voltage line in parallel. The first switch group includes first, second, and third switches. The first switch is inserted between the first input terminal and the first capacitor. The second switch is inserted between the first input terminal and the second capacitor. The third switch is inserted between the second input terminal and the first capacitor. The fourth switch is inserted between the first capacitor and the first output terminal. The fifth switch is inserted between the second capacitor and the first output terminal. The sixth switch is inserted between the second capacitor and the second output terminal. The first, second, and third switches are simultaneously or individually turned on and the fourth, fifth, and sixth switches are turned off when the first and second capacitors are charged. After charging the first and second capacitors, the fourth and sixth switches are turned on and then the fifth and sixth switches are turned on, or the fifth and sixth switches are turned on and then the fourth and sixth switches are turned on.

### BRIEF DESCRIPTION OF THE DRAWINGS

FIG 1 is a diagram illustrating a schematic configuration of a battery voltage detector 1 in accordance with one embodiment of the present invention;
FIG 2 is a schematic circuit diagram of a cell voltage detection circuit D1 in accordance with one embodiment of the present invention;
FIG 3 is a timing chart showing an operation of a battery voltage detector 1 in accordance with one embodiment of the present invention; and
FIG 4 is a graph showing (a) a V-IL characteristic of a detected voltage value V input to a microcomputer M and leakage current IL which occurred in the cell voltage detection circuit D1, (b) a ΔV-IL characteristic of a difference ΔV between a first cell voltage V_FC1 and a second cell voltage V FC2 and the leakage current IL, and (c) a state of a defect flag, in accordance with one embodiment of the present invention.

### DETAILED DESCRIPTION OF THE INVENTION

Hereinafter, one embodiment of the present invention will be described with reference to the drawings.

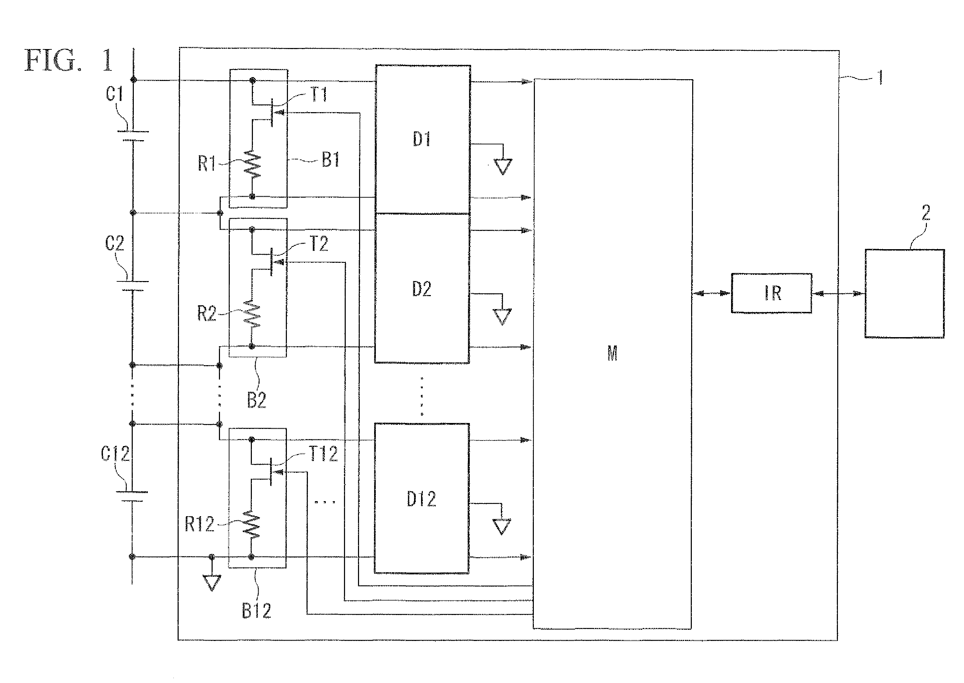

FIG 1 is a diagram illustrating a schematic configuration of a battery voltage detector 1 in accordance with one embodiment of the present invention. As shown in FIG 1, a battery voltage detector 1 is an ECU (Electronic Control Unit) which has a function of detecting cell voltages of twelve battery cells C1 to C12 and a function of performing a cell balance control (homogenization of the cell voltages) of each of the battery cells C1 to C12. The battery cells C1 to C12 form a battery. The battery voltage detector 1 includes twelve bypass circuits B1 to B12, twelve cell voltage detection circuits D1 to D12, a microcomputer M (voltage processor), and an insulating element IR.

Each of the bypass circuits B1 to B12 is constructed by a series circuit of a bypass resistance and a switching element such as a transistor. The bypass circuits B1 to B12 are connected to the battery cells C1 to C12 in parallel, respectively. R1 to R12 denote the bypass resistances included in the bypass circuits B1 to B12, respectively. In FIG 1, T1 to T12 denote the switching elements included in the bypass circuits B1 to B12, respectively.

The cell voltage detection circuits D1 to D12 are connected to the battery cells C1 to C12 in parallel, respectively. Each of the cell voltage detection circuits D1 to D12 detects a voltage between terminals of each of the battery cells C1 to C12 and output the detected cell voltage to the microcomputer M. Although an explanation will be made in detail later, each of the cell voltage detection circuits D1 to D12 simultaneously charges two capacitors (flying capacitors) by the corresponding battery cell in one cycle of a voltage detection cycle. After that, each of the cell voltage detection circuits D1 to D12 outputs voltages between both terminals of the two capacitors as cell voltages to the microcomputer M at different timing.

The microcomputer M is a microcontroller integrally embedded with memories such as a ROM and a RAM, a CPU (Central Processing Unit), an A/D converter, an input/output interface, and the like. The microcomputer M has a function of judging whether or not a false detection of the cell voltage is generated (whether or not a defect is generated in the cell voltage detection circuits D1 to D12) based on two cell voltages obtained from each of the cell voltage detection circuit D1 to D12 at different timing in one cycle of the voltage detection cycle.

The microcomputer M is coupled to a battery ECU 2 which is an upper controller via the insulating element IR to communicate each other. The microcomputer M has a function of transmitting the cell voltage detection result of each of the battery cells C1 to C12 to the battery ECU 2. Two cell voltages of each of the battery cells C1 to C12 are obtained in one cycle of the voltage detection cycle. Since two cell voltages are approximately the same in the case where the false detection of the cell voltage does not occur (in the case where the cell voltage detection circuit is normal), one of the two cell voltages, for example, a cell voltage obtained from the flying capacitor FC1 may be transmitted to the battery ECU 2 as the cell voltage detection result.

The battery ECU 2 monitors a balance state of the cell voltage based on the cell voltage detection results of each of the battery cells C1 to C12 which are received from the microcomputer M. When the battery ECU 2 finds a battery cell whose cell voltage is higher compared to that of other battery cells, the battery ECU 2 identifies the battery cell as a cell necessitating discharge and transmits the identification result to the microcomputer M. The micro computer M has a function of duty control of the switching element of the bypass circuit connected to the cell necessitating discharge, that is, a cell balance control. In the cell balance control, when the microcomputer M receives the identification result of the cell necessitating discharge from the battery ECU 2, predetermined discharging current flows in the bypass circuit connected to the cell necessitating discharge.

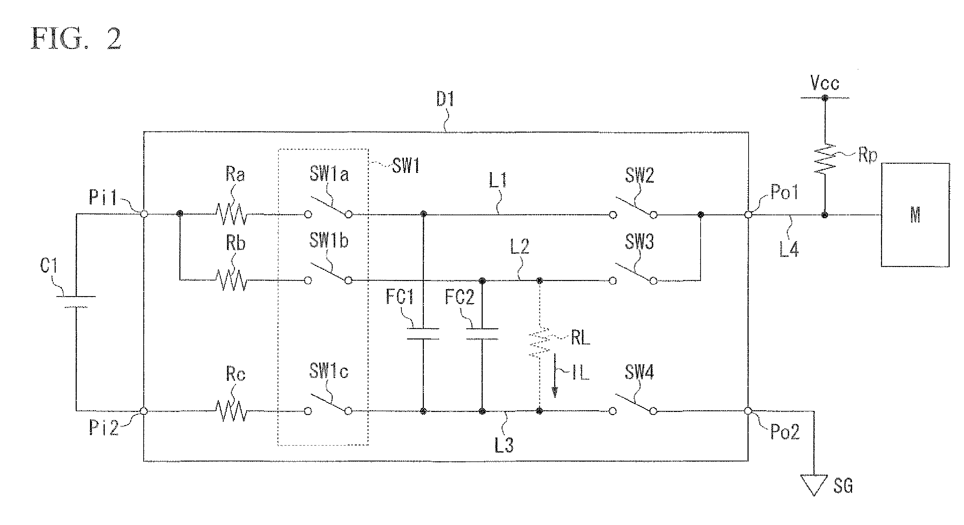

FIG 2 is a schematic circuit diagram of a cell voltage detection circuit D1 which detects a cell voltage of the battery cell C1. Since the other cell voltage detection circuits D2 to D12 have the same circuit configuration, the cell voltage detection circuit D1 is used as a representative example and the circuit configuration thereof will be described in detail. As shown in FIG 2, reference numeral Pil denotes a first input terminal connected to a positive terminal of the battery cell C1. Reference numeral Pi2 denotes a second input terminal connected to a negative terminal of the battery cell C1. Reference numeral Pol denotes a first output terminal connected to an input port of the microcomputer M, which is a port connected to the A/D converter. Reference numeral Po2 denotes a second output terminal connected to a common line which is a grounded line SG for example, in the battery voltage detector 1.

Reference numeral FC1 denotes a first flying capacitor, which is also referred to as a first capacitor, connected between a first high voltage line L1 and a low voltage line L3. The first high voltage line L1 connects the first input terminal Pil and the first output terminal Pol. The low voltage line L3 connects the second input terminal Pi2 and the second output terminal Po2. Reference numeral FC2 denotes a second flying capacitor, which is also referred to as a second capacitor, connected between a second high voltage line L2 and the low voltage line L3. The second high voltage line L2 is connected to the first high voltage line L1 in parallel.

Reference numeral SW1 denotes a first switch group inserted in a former stage of the first flying capacitor FC1 and the second flying capacitor FC2 in the first high voltage line L 1, the second high voltage line L2, and the low voltage line L3. Specifically, the first switch group SW1 includes the first switch SW1a, the first switch SW1b, and the first switch SW1c. The first switch SW1a is inserted in a former stage of the first flying capacitor FC1 in the first high voltage line L1. The first switch SW1b is inserted in a former stage of the second flying capacitor FC2 in the second high voltage line L2. The first switch SW1c is inserted in a former stage of the first flying capacitor FC1 and the second flying capacitor FC2 in the low voltage line L3. In other words, the first switch SW1a is inserted between the first input terminal Pil and the first flying capacitor FC1. The first switch SW1b is inserted between the first input terminal Pil and the second flying capacitor FC2. The first switch SW1c is inserted between the second input terminal Pi2 and the first flying capacitor FC1.

An input resistor Ra is inserted in a former stage of the first switch SW1a in the first high voltage line L1. An input resistor Rb is inserted in a former stage of the first switch SW1b in the second high voltage line L2. An input resistor Rc is inserted in a former stage of the first switch SW1c in the low voltage line L3.

Reference numeral SW2 denotes a second switch inserted in a later stage of the first flying capacitor FC1 in the first high voltage line L1. Reference numeral SW3 denotes a third switch inserted in a later stage of the second flying capacitor FC2 in the second high voltage line L2. Reference numeral SW4 denotes a fourth switch inserted in a later stage of the first flying capacitor FC1 and the second flying capacitor FC2 in the low voltage line L3. The second switch SW2 is inserted between the first flying capacitor FC1 and the first output terminal Pol. The third switch SW3 is inserted between the second flying capacitor FC2 and the first output terminal Pol. The fourth switch SW4 is inserted between the second flying capacitor FC2 and the second output terminal Po2.

A line L4 connecting the first output terminal Po1 and the microcomputer M is connected to a voltage line (a voltage line in the case where Vcc is 5V, for example) in the battery voltage detector 1 via a pull-up resistor Rp. Although not shown in the drawings, the voltage line is connected to a reference voltage source which generates a stable reference voltage (Vcc). The reference voltage (Vcc) is a reference of circuit operation.

In FIG 2, a leakage resistor RL shown in a broken line does not exist as an actual circuit element in the cell voltage detection circuit D1. The leakage resistor RL is illustrated in order to equivalently describe how leak current IL, which is generated because of aging of the cell voltage detection circuit D1, flows. When aging of the cell voltage detection circuit D1 progresses, resistance of the leakage resistor RL decreases and the leakage current IL increases.

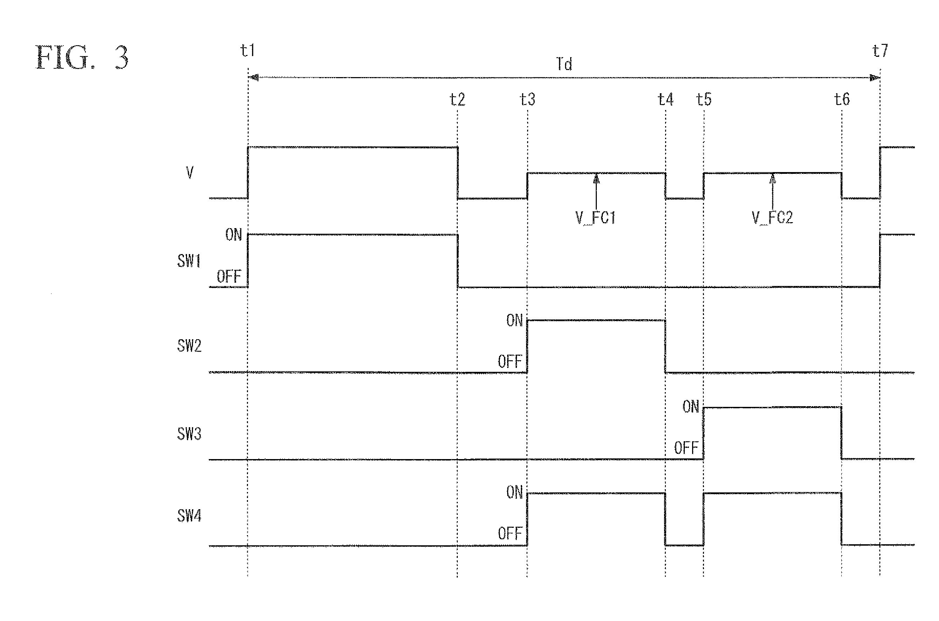

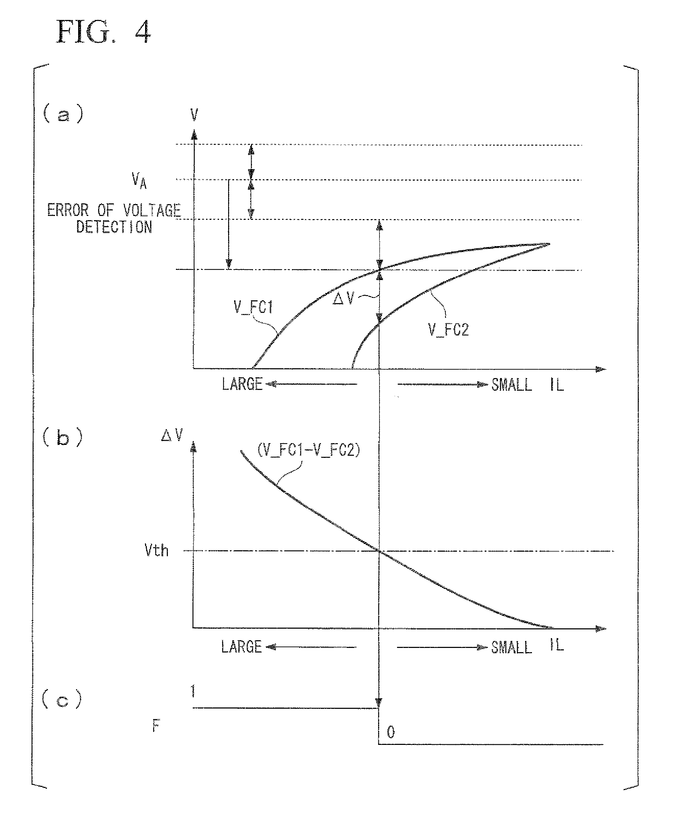

The above is an explanation regarding the configuration of the battery voltage detector 1 according to the present embodiment. An operation of the battery voltage detector 1 having the configuration described above will be described in detail with reference to FIGS. 3 and 4. In particular, the operation when judging whether or not a false detection of the cell voltage has occurred (whether or not the defect of the cell voltage detection circuit generated), which is one feature of the present embodiment, will be described.

The cell voltage detection circuit D1 which detects the cell voltage of the battery cell C1 is used as a representative example and the operation when judging whether or not a false detection of the cell voltage has occurred will be described. However, the cell voltage detection circuits D2 to D12 operate in the same manner as the cell voltage detection circuit D1.

FIG 3 is a timing chart showing a chronological correspondence between the detected voltage value V and on/off states of the first switch group SW1, the second switch SW2, the third switch SW3, and the fourth switch SW4 of the cell voltage detection circuit D1 in one cycle of the voltage detection cycle Td. Here, the detected voltage value V is input from the cell voltage detection circuit D1 to the microcomputer M. Namely, the detected voltage value V is a voltage between the first output terminal Pol and the second output terminal Po2 of the cell voltage detection circuit D1.

As shown in FIG 3, if a start timing, which is a start timing of charging the first flying capacitor FC1 and the second flying capacitor FC2, of the voltage detection cycle Td comes at t1, the second switch SW2, the third switch SW3 and the fourth switch SW4 are turned off while the first switching group SW (SW1 a, SW1b, and SW1c) of the cell voltage detection circuit D1 is turned on. By doing this, the first flying capacitor FC1 and the second flying capacitor FC2 are started to be charged by the battery cell C1.

The first switching group SW1 is turned off at t2 after a certain time has passed from t1. Namely, the first switching group SW1 is turned off after the first flying capacitor FC1 and the second flying capacitor FC2 have been fully charged. In the period between t1 and t2, since the cell voltage detection circuit D1 and the microcomputer M are electrically disconnected to each other, the detected voltage value V corresponding to Vcc is input to the microcomputer M via the pull-up resistor Rp.

After charging the first flying capacitor FC1 and the second flying capacitor FC2, the second switch SW2 and the fourth switch SW4 are turned on in a period between t3 and t4. In this period, the first switch group SW1 and the third switch SW3 are turned off. By doing this, in the period between t3 and t4, the detected voltage value V corresponding to a voltage between terminals of the first flying capacitor F1 V_FC1 is input to the microcomputer M.

When the detected voltage value V corresponding to the voltage between terminals of the first flying capacitor F1 V_FC1 is input to the microcomputer M, the detected voltage value V is converted, by the A/D converter, to digital data which is processable by the CPU. The microcomputer M (actually the CPU) memorizes the digital data of the detected voltage value V obtained in the period between t3 and t4 as a first cell voltage in an internal memory such as the RAM Hereinafter, the first cell voltage is referred to as a first cell voltage V FC1.

After obtaining the first cell voltage V_FC1, the third switch SW3 and the fourth switch SW4 are turned on in a period between t5 and t6. In this period, the first switch group SW1 and the second switch SW2 are turned off. By doing this, in the period between t5 and t6, the detected voltage value V corresponding to a voltage between terminals of the second flying capacitor F2 V_FC2 is input to the microcomputer M.

When the detected voltage value V corresponding to the voltage between terminals of the second flying capacitor F2 V_FC2 is input to the microcomputer M, the detected voltage value V is converted, by the A/D converter, to digital data which is processable by the CPU. The microcomputer M (actually the CPU) memorizes the digital data of the detected voltage value V obtained in the period between t5 and t6 as a second cell voltage in the internal memory such as the RAM Hereinafter, the second cell voltage is referred to as a second cell voltage V-FC2.

When the microcomputer M obtains two cell voltages, that is, the first cell voltage V_FC1 and the second cell voltage V_FC2, as described above, the microcomputer M reads out the first cell voltage V_FC1 and the second cell voltage V_FC2 from the internal memory and calculates a difference ΔV (= V_FC1 - V_FC2) between the first cell voltage V_FC1 and the second cell voltage V-FC2.
(a) of FIG 4 is a graph showing a V-IL characteristic of the detected voltage value V input to the microcomputer M and leakage current IL which occurs in the cell voltage detection circuit D1. (b) of FIG 4 is a ΔV-IL characteristic of the difference ΔV between the first cell voltage V_FC1 and the second cell voltage V_FC2 and the leakage current IL.

As shown in FIG 4, an error of the first cell voltage V_FC1 and the second cell voltage V_FC2 with respect to an actual cell voltage V_{A} of the battery cell C1 is increased as the leakage current IL becomes larger because of aging of the cell voltage detection circuit D1. Thereby, the difference ΔV between the first cell voltage V_FC1 and the second cell voltage V_FC2 become larger. Therefore, when the difference ΔV exceeds a threshold value Vth which is the minimum acceptable value, it is possible to judge that a false detection of the cell voltage has occurred (a defect of the cell voltage detection circuit D1 was generated).

The microcomputer M judges whether or not the difference ΔV between the first cell voltage V_FC1 and the second cell voltage V_FC2, which is calculated as described above, exceeds the threshold value Vth. In the case where the difference ΔV exceeds the threshold value Vth, the microcomputer M judges that a false detection of the cell voltage has occurred (a defect of the cell voltage detection circuit D1 was generated) and sets a defect flag F as "1". On the other hand, in the case where the difference ΔV is lower than the threshold value Vth, the microcomputer M judges that the cell voltage is correctly detected (the cell voltage detection circuit D1 is normal) and sets the defect flag F as "0" (refer to (c) of FIG 4).

In the case where the microcomputer M sets the defect flag F as "0", the microcomputer M sends, to a battery ECU2, one of the first cell voltage V_FC1 and the second cell voltage V_FC2 as the detection result of the cell voltage of the battery cell C1. In the case where the microcomputer M sets the defect flag F as "1", the microcomputer M sends the defect flag F to the battery ECU2 instead of the detection result of the cell voltage of the battery cell C1, and notifies the battery ECU2 that a false detection of the cell voltage has occurred (a defect of the cell voltage detection circuit D1 is generated).

The battery voltage detector 1 continuously monitors whether or not a false detection of the cell voltage of each battery cells C1 to C12 has occurred (a defect of the cell voltage detection circuits D1 to D12 was generated) by repeatedly performing the above described sequence of operations in the voltage detection cycle Td. In the case where a false detection of the cell voltage has occurred (the defect of the cell voltage detection circuit D1 was generated), the microcomputer M timely notifies the battery ECU2. Here, the on/off states of the first switching group SW1, the second switch SW2, the third switch SW3, and the fourth switch SW4 may be controlled by the microcomputer M. Also, another controller may be provided and control the on/off states.

As described above, according to the present embodiment, it is judged whether or not a false detection of the cell voltage has occurred based on two cell voltages (a first cell voltage V_FC1 and the second cell voltage V_FC2) obtained at different timing from each cell voltage detection circuits D1 to D12. By virtue of this, an occurrence of the false detection of the cell voltage (generation of a defect of the cell voltage detection circuit) caused by aging (increase of the leakage current) of the flying capacitor-type cell voltage detection circuits D1 to D12 can be detected by a simple configuration. As a result, it contributes to the proper control of the battery.

The present invention is not limited to the above-described embodiment, and modified examples can be given as follows.
(1) According to the above-described embodiment, after charging the first flying capacitor FC1 and the second flying capacitor FC2, the second switch SW2 and the fourth switch SW4 are turned on. Then, the third switch SW3 and the fourth switch SW4 are turned on. Namely, the voltage between the terminals of the first flying capacitor FC1 V_FC1 is obtained, and then the voltage between the terminals of the second flying capacitor FC2 V_FC2 is obtained.

On the other hand, after charging the first flying capacitor FC1 and the second flying capacitor FC2, the third switch SW3 and the fourth switch SW4 may be turned on and then the second switch SW2 and the fourth switch SW4 may be turned on. Namely, the voltage between the terminals of the second flying capacitor FC2V_FC2 may be obtained, and then the voltage between the terminals of the first flying capacitor FC1 V_FC1 is obtained.

According to the above-described embodiment, the on/off states of the entire first switch group SW1 (SW1a, SW1b, and SW1c) are controlled. However, the on/off states of the switches (SW1a, SW1b, and SW1c) of the first switch group SW1 may be individually controlled. Namely, the on/off states of the first switches SW1a, SW1b, and SW1c may be sequentially controlled.
(2) According to the above-described embodiment, one example of the circuit configuration of the cell voltage detection circuits D1 to D12 is described with reference to FIG 2. However, the circuit configuration of the cell voltage detection circuits D1 to D12 is not limited thereto. Any configuration may be applied to the circuit configuration of the cell voltage detection circuits D1 to D12 if the cell voltage detection circuits D1 to D12 have a configuration which outputs voltages between terminals of two capacitors (flying capacitors) as cell voltages to the microcomputer M at different timing after simultaneously charging two capacitors by the battery cell. Additionally, one cell voltage detection circuit may be provided with three or more flying capacitors.
(3) According to the above-described embodiment, the battery voltage detector 1 which performs cell voltage detection of the twelve battery cells C1 to C12 is exemplarily shown. However, the number of battery cells to be detected is not limited to twelve. Further, an example in which twelve cell voltage detection circuits D1 to D12 are provided in correspondence with the battery cells C1 to C12 is shown in the first embodiment. However, one cell voltage detection circuit may be provided and cell voltages of each of the battery cells C1 to C12 may be sequentially detected while both terminals of the battery cells C1 toCl2 and both input terminals (the first input terminal Pil and the second input terminal Pi2) of the cell voltage detection circuit are sequentially connected by a multiplexer. When the multiplexer is used, the first switch group SW1 is unnecessary.

When the plurality of capacitors are simultaneously charged by the battery cell and then the voltages between both terminals of the plurality of capacitors are detected as the cell voltages at different timing, the greater the leakage current caused by aging of the voltage detection circuit is, the greater the difference between the cell voltages.

According to the present invention, whether or not a false detection of the cell voltage has occurred is judged based on the cell voltages obtained from the voltage detection circuit described above at different timing. By virtue of this, the occurrence of a false detection of the cell voltage (generation of the defect of the cell voltage detection circuit) caused by aging (increase of the leakage current) of the cell voltage detection circuits can be detected by a simple configuration. As a result, it contributes to the proper control of the battery.

While preferred embodiments of the invention have been described and illustrated above, it should be understood that these are exemplary of the invention and are not to be considered as limiting. Additions, omissions, substitutions, and other modifications can be made without departing from the scope of the present invention. Accordingly, the invention is not to be considered as being limited by the foregoing description, and is only limited by the scope of the appended claims.

## Claims

1. A battery voltage detector comprising:
a voltage detection circuit (D1) for detecting a first cell voltage of a first battery cell (Cl), the voltage detection circuit (D1) comprising a plurality of capacitors (FC1 and FC2) which are simultaneously charged by the first battery cell (C1); and
a voltage processor (M) for processing the detection result of the cell voltage,
wherein the voltage detection circuit (D1) outputs the voltages between both terminals of the plurality of capacitors as a plurality of second cell voltages to the voltage processor (M) at different timing, and
the voltage processor (M) judges whether or not a false detection of the first cell voltage occurs based on the plurality of second cell voltages obtained from the voltage detection circuit (D1) at different timing.

2. The battery voltage detector according to Claim 1, wherein the voltage processor (M) judges that the false detection of the first cell voltage has occurred when a difference of the plurality of second cell voltages exceeds a predetermined threshold value.

3. The battery voltage detector according to Claim 1 or 2, wherein the voltage detection circuit (D1) is provided to each of a plurality of second battery cells (C1 to C12) including the first battery cell (C1),
wherein each of the voltage detection circuit (D1) comprises:
a first input terminal (Pil) coupled to a positive terminal of the second battery cell (C1);
a second input terminal (Pi2) coupled to a negative terminal of the second battery cell(C1);
a first output terminal (Po1) coupled to the voltage processor (M);
a second output terminal (Po2) coupled to a common line (SG);
a first capacitor (FC1) coupled between a first high voltage line (L1) and a low voltage line (L3), the first high voltage line (L1) coupling the first input terminal (Pil) and the first output terminal (Po1), the low voltage line (L3) coupling the second input terminal (Pi2) and the second output terminal (Po2),
a second capacitor (FC2) coupled between a second high voltage line (L2) and the low voltage line (L3), the second high voltage line (L2) coupled to the first voltage line (L1) in parallel;
a first switch group (SW1) including a first switch (SW1a), a second switch (SW1b), and a third switch (SW1c), the first switch (SW1a) being inserted between the first input terminal (Pil) and the first capacitor (FC1), the second switch (SW1b) being inserted between the first input terminal (Pil) and the second capacitor (FC2), and the third switch (SW1c) being inserted between the second input terminal (Pi2) and the first capacitor (FC1);
a fourth switch (SW2) inserted between the first capacitor (FC1) and the first output terminal (Pol);
a fifth switch (SW3) inserted between the second capacitor (FC2) and the first output terminal (Pol); and
a sixth switch (SW4) inserted between the second capacitor (FC2) and the second output terminal (Po2),
wherein the first switch (SW1a), the second switch (SW1b), and the third switch (SW1c) are simultaneously or individually turned on and the fourth switch (SW2), the fifth switch (SW3), and the sixth switch (SW4) are turned off when the first capacitor (FC1) and the second capacitor (FC2) are charged, and
wherein after charging the first capacitor (FC1) and the second capacitor (FC2), the fourth switch (SW2) and the sixth switch (SW4) are turned on and then the fifth switch (SW3) and the sixth switch (SW4) are turned on, or the fifth switch (SW3) and the sixth switch (SW4) are turned on and then the fourth switch (SW2) and the sixth switch (SW4) are turned on.
